**Europäisches Patentamt**

**European Patent Office** · (11) Veröffentlichungsnummer: **0 017 980**

**Office européen des brevets** **B1**

(19)

(12) **EUROPÄISCHE PATENTSCHRIFT**

(45) Veröffentlichungstag der Patentschrift:
12.10.83

(51) Int. Cl.³: **H 01 L 29/743**

(21) Anmeldenummer: **80102046.2**

(22) Anmeldetag: **16.04.80**

(54) Thyristor mit Steuerung durch Feldeffekttransistor.

(30) Priorität: **19.04.79 DE 2915885**

(43) Veröffentlichungstag der Anmeldung:
**29.10.80 Patentblatt 80/22**

(45) Bekanntmachung des Hinweises auf die Patenterteilung:
**12.10.83 Patentblatt 83/41**

(84) Benannte Vertragsstaaten:
**CH FR GB IT LI**

(56) Entgegenhaltungen:
**DE-B-1 211 334**
**FR-A-2 110 299**

**IBM TECHNICAL DISCLOSURE BULLETIN, Band 20,
Nr. 6, November 1977, Seiten 2273–2274 New York,
USA. F.A. PERNER et al.: "MOS Gate Turn-Off Lateral
SCR"**

(73) Patentinhaber: **SIEMENS AKTIENGESELLSCHAFT,
Berlin und München Wittelsbacherplatz 2,
D-8000 München 2 (DE)**

(72) Erfinder: **Tihanyi, Jenö, Dr. Ing. Dipl. Phys.,
Wolfratshauser Strasse 179 b, D-8000 München 71 (DE)**

Thyristor mit Steuerung durch Feldeffekttransistor

Die Erfindung bezieht sich auf einen Thyristor mit einem Halbleiterkörper mit den Merkmalen:

Der Halbleiterkörper hat vier Zonen abwechselnden Leitungstyps;

zwischen den Zonen liegt jeweils ein pn-Übergang;

die erste Zone liegt an der ersten Oberfläche des Halbleiterkörpers;

die zweite Zone grenzt an die erste Zone und tritt an die erste Oberfläche;

die dritte Zone grenzt an die zweite und vierte Zone und tritt an die erste Oberfläche;

die erste Zone ist mit einer Elektrode kontaktiert und mit der zweiten Zone über einen Nebenschluss verbunden;

in den gleichen Halbleiterkörper ist ein FET integriert, der zur Überbrückung des zwischen zweiter und dritter Zone liegenden pn-Übergangs bestimmt ist;

die Source- und Drainzone des FET liegen an der ersten Oberfläche. Ein derartiger Thyristor mit einem in den gleichen Halbleiterkörper integrierten Feldeffekttransistor ist aus der DE-B-1 211 334 bekannt.

Allgemein gebräuchliche Thyristoren benötigen in grösseren Ausführungen zum Zünden Ströme von 10 mA und mehr. Sollen solche Thyristoren von Mikrocomputern oder Speicherschaltungen angesteuert werden, so sind Stromverstärker notwendig, die einen relativ hohen Aufwand darstellen. Auf Grund des Einschaltmechanismus eines Thyristors, den man sich aus zwei rückgekoppelten Transistoren bestehend vorstellen kann, benötigen solche bipolaren Thyristoren zum Zünden relativ viel Zeit, die in der Grössenordnung von 10 µs bis zu einigen ms liegen kann. Für manche Anwendungszwecke sind jedoch äusserst schnell schaltende Thyristoren erwünscht.

Der Erfindung liegt die Aufgabe zugrunde, einen Thyristor der eingangs erwähnten Art so weiterzubilden, dass er mit wesentlich geringerer Leistung als bisher bekannte Thyristoren äusserst schnell angesteuert werden kann.

Die Erfindung ist gekennzeichnet durch folgende Merkmale:

Die Sourcezone ist in der zweiten Zone angeordnet;

der Kanal wird in einem an die erste Oberfläche tretenden Teil der zweiten Zone, der die Gatezone bildet, erzeugt;

die dritte Zone ist im Vergleich zu den anderen Zonen schwach dotiert und ihr an die erste Oberfläche angrenzender Teil bildet die Drainzone des FET.

Weiterbildungen der Erfindung sind Gegenstand der Unteransprüche.

Die Erfindung wird an Hand zweier Ausführungsbeispiele in Verbindung mit den Fig. 1 bis 3 näher erläutert. Es zeigen:

Fig. 1 das Prinzipschaltbild des erfindungsgemässen Thyristors,

Fig. 2 einen Schnitt durch den Halbleiterkörper eines ersten Thyristors und

Fig. 3 den Schnitt durch einen Halbleiterkörper eines zweiten Thyristors.

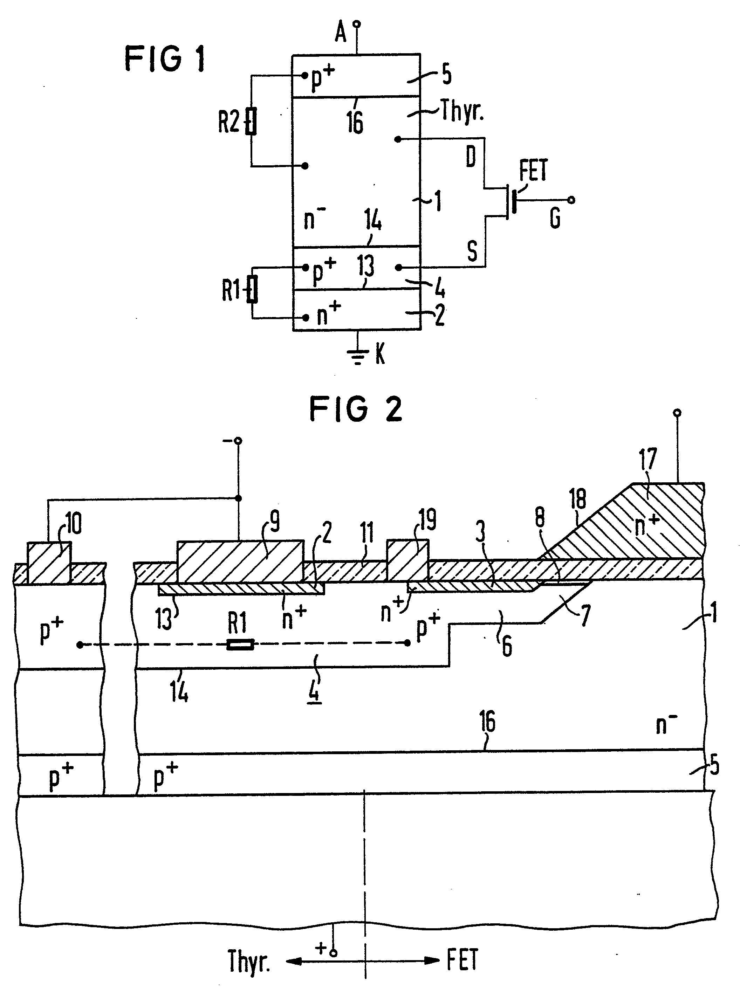

Das Prinzipschaltbild in Fig. 1 zeigt einen aus vier Zonen 2, 4, 1, 5 abwechselnden Leitfähigkeitstyps bestehenden Halbleiterkörper eines Thyristors Thyr. Die n-leitende dritte Zone 1 und die angrenzende p-dotierte zweite Zone 4 sind durch einen pn-Übergang 14 voneinander getrennt, der durch die Laststrecke eines Feldeffekttransistors FET überbrückt ist. Dabei ist die zweite Zone 4 mit der Sourceelektrode S und die dritte Zone 1 mit der Drainelektrode D des Feldeffekttransistors verbunden.

Bei der eingezeichneten Polarität der am Thyristor liegenden Spannung werde an die Gateelektrode G des FET eine Steuerspannung angelegt. Dabei fliessen negative Ladungsträger aus der ersten Zone 2 über den in Durchlassrichtung vorgespannten pn-Übergang 13 in die zweite Zone 4 und von da über die Laststrecke des FET in die dritte Zone 1. Gleichzeitig fliessen aus der p-dotierten vierten Zone 5 Löcher über den durchlässigen pn-Übergang 16 in die dritte Zone 1 des Thyristors. Damit wird der pn-Übergang 14 in Durchlassrichtung vorgespannt. Das heisst, dass die beiden Teiltransistoren des Thyristors unmittelbar ohne die bei üblichen bipolaren Thyristoren mittelbar angeregte Injektion von Löchern aus der äusseren anodenseitigen Zone eingeschaltet werden. Dies bedeutet, dass der Thyristor durch Anlegen einer Steuerspannung an die Gateelektrode G äusserst schnell eingeschaltet werden kann. Die Steuerung erfolgt dabei, wie bei durch Feldeffekt gesteuerten Bauelementen üblich, bis auf dielektrische Verluste nahezu leistungslos.

Die eingezeichneten Widerstände R 1 und R 2 sind zur Funktion des Bauelements nicht unbedingt erforderlich. Es empfiehlt sich jedoch, wie bei Thyristoren allgemein üblich, zur Verbesserung des du/dt-Verhaltens wenigstens auf der Seite der Kathode K einen Emitter-Basis-Nebenschluss vorzusehen, der durch den Widerstand R 1 repräsentiert wird. Eine weitere Verbesserung kann durch einen auf der Seite der Anode A angeordneten Nebenschluss erreicht werden, der durch den Widerstand R 2 dargestellt ist.

Der in Fig. 2 dargestellte Halbleiterkörper weist wie im Prinzipbild nach Fig. 1 eine schwach n-dotierte dritte Zone 1, eine daran angrenzende stark p-dotierte zweite Zone 4 und eine erste Zone 2 auf, die stark n-dotiert ist. Die vierte Zone 5 ist stark p-dotiert. Die genannten Zonen sind durch die pn-Übergänge 13, 14, 16 voneinander getrennt. Die genannten Zonen bilden den Thyristorteil Thyr des Halbleiterkörpers. Weiterhin weist der Halbleiterkörper eine stark n-dotierte Zone 3 auf, die auf der ersten Oberfläche des Halbleiterkörpers liegt. Diese Zone 3 kann die gleiche Tiefe wie die erste Zone 2 und die gleiche Dotierungskonzentration wie diese aufweisen. Die Gatezone des Feldeffekttransistors wird durch ein Teil 6 der zweiten Zone 4 des Thyristors gebildet. Dieser Teil 6 ist zweckmässigerweise wenigstens teilweise dünner ausgebildet als der zum Thyristor gehörende Teil der zweiten Zone 4. Die dritte Zone 1 tritt neben der Gatezone 6 an die Oberfläche des Halbleiterkörpers. Die Zone 3 bildet dann die Sourcezone und ein Teil der dritten Zone 1 die Drainzone des in den Halbleiterkörper integrierten FET.

Zweckmässigerweise werden zumindest die Sourcezone 3 und die Gatezone 6 durch Ionenimplantation hergestellt. Damit kann man insbesondere eine sehr geringe Dicke der Gatezone 6 und damit eine äusserst kurze Kanallänge des FET erreichen. Damit wird eine hohe Schaltgeschwindigkeit erzielt. Zur Herstellung der Gatezone 6 durch Ionenimplantation empfiehlt es sich, eine aus hochdotiertem n-leitendem polykristallinem Silicium bestehende Gateelektrode zu verwenden. Die Gateelektrode 17 wird auf einer den Halbleiterkörper bedeckenden Isolierschicht 11 angebracht, die beispielsweise aus Siliciumdioxid $SiO_2$ besteht. Die Gateelektrode 17 weist mindestens eine schräg zum Rand hin abfallende Flanke 18 auf, die als Maske für die Ionenimplantation derart wirkt, dass die Gatezone 6 des FET einen Bereich 7 erhält, der zur Oberfläche des Halbleiterkörpers schräg ansteigende Flanken hat. Damit lässt sich die Kanallänge des FET genau einstellen.

Die erste Zone 2 des Thyristors ist mit einer Katodenelektrode 9 versehen, die an einer von der Sourcezone 3 des FET entfernten Stelle einen Nebenschluss 10 mit der zweiten Zone 4 bildet. Die Sourcezone 3 des FET kann mit einem Nebenschluss 19 zur zweiten Zone 4 versehen sein. Für die Funktion des Bauelements ist dieser jedoch nicht unbedingt erforderlich.

Zur Erläuterung der Funktion des Bauelements wird von der eingezeichneten Polarität der am Thyristor liegenden Spannung ausgegangen. Liegt an der Steuerelektrode 17 keine Spannung, so ist der pn-Übergang 14 in Sperrichtung vorgespannt und der Thyristor ist gesperrt. Wird an die Gateelektrode 17 positives Potential angelegt, so bildet sich an der Oberfläche des Halbleiterkörpers in der Gatezone 6 des FET ein n-leitender Kanal 8 aus, durch den die Sourcezone 3 mit der dritten Zone 1 verbunden wird. Damit wird der in Sperrichtung vorgespannte pn-Übergang 14 überbrückt. Es fliessen dann negative Ladungsträger von der Katode durch die Zone 4 in die Zone 3 und durch den Kanal 8 in die Innenzone 1. Damit wird der pn-Übergang 13 in Durchlassrichtung vorgespannt und die erste Zone 2 zur Injektion von negativen Ladungsträgern in die zweite Zone 4 veranlasst. Diese gelangen durch Diffusion zum pn-Übergang 14. Gleichzeitig mit dem Fluss von negativen Ladungsträgern durch den Kanal 8 in die dritte Zone 1 wird der pn-Übergang 16 in Flussrichtung vorgespannt und zur Injektion von positiven Ladungsträgern in die dritte Zone 1 gebracht. Diese diffundieren zum in Sperrichtung vorgespannten pn-Übergang 14. Der pn-Übergang 14 wird dann durch Überschwemmen von Ladungsträgern beider Polarität in Durchlassrichtung vorgespannt und der Thyristor zündet.

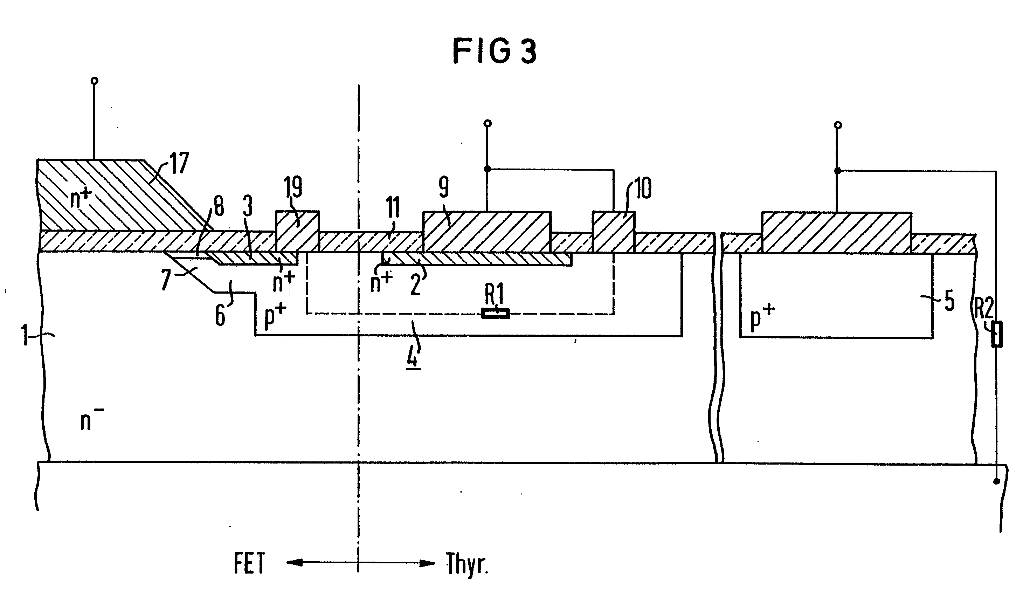

Das Ausführungsbeispiel nach Fig. 3 unterscheidet sich von dem nach Fig. 2 lediglich dadurch, dass hier die vierte Zone 5 des Thyristors seitlich neben der Kathode an der ersten Oberfläche des Halbleiterkörpers angeordnet ist. Im übrigen sind dem Ausführungsbeispiel nach Fig. 2 in der Funktion gleiche Teile mit gleichen Bezugszeichen versehen.

Der beschriebene Thyristor kann wie folgt dimensioniert sein:

Dicke der ersten Zone 2 und der Sourcezone 3 ca. 0,1 bis 0,2 μm, Dotierung $10^{18}$ bis $10^{20}$ cm$^{-3}$; Dicke der dritten Zone 1: ca. 10 bis 100 μm, Dotierung $5 \cdot 10^{13}$ bis $5 \cdot 10^{15}$ cm$^{-3}$; Randdotierung der zweiten Zone 4: $10^{16}$ bis $10^{17}$, Dicke ca. 0,5 bis 5 μm; Dicke der Gatezone 6: 0,3 bis 1 μm, Implantation Dosis 2 bis $5 \cdot 10^{12}$ cm$^{-2}$, Energie 150 bis 200 keV; Dicke der Gateelektrode 17: 0,4 bis 1 μm; Kanallänge ca. 0,5 μm, laterale Ausdehnung der Anordnung ca. 100 μm.

Mit einem solchen Thyristor konnte eine Spannung bis 200 V und eine Stromstärke von 1 A erzielt werden. Die Einschaltzeit des Thyristors lag dabei etwa bei 50 ns. Zur Erhöhung der Belastbarkeit können, wie aus der Technik der integrierten Halbleiterschaltkreise bekannt, eine Vielzahl der beschriebenen, aus einem Thyristor und einem FET bestehenden Strukturen auf einem Chip angeordnet und parallel geschaltet werden.

Die beschriebene Form der Gatezone 6 ist für die Funktion des Thyristors nicht notwendig. Es kann auch eine ebene, unter die Gateelektrode reichende Steuerzone verwendet werden, wie sie zum Beispiel in der DE-A-2 611 338 beschrieben ist.

**Patentansprüche**

1. Thyristor mit einem Halbleiterkörper mit den Merkmalen:

Der Halbleiterkörper hat vier Zonen (2, 4, 1, 5) abwechselnden Leitungstyps;

zwischen den Zonen liegt jeweils ein pn-Übergang (13, 14, 16);

die erste Zone (2) liegt an der ersten Oberfläche des Halbleiterkörpers;

die zweite Zone (4) grenzt an die erste Zone (2) und tritt an die erste Oberfläche;

die dritte Zone (1) grenzt an die zweite und vierte Zone und tritt an die erste Oberfläche;

die erste Zone (2) ist mit einer Elektrode (9) kontaktiert und mit der zweiten Zone (4) über einen Nebenschluss (10) verbunden;

in den gleichen Halbleiterkörper ist ein FET integriert, der zur Überbrückung des zwischen zweiter und dritter Zone liegenden pn-Übergangs (14) bestimmt ist;

die Source- und Drainzone (3, 1) des FET liegen an der ersten Oberfläche;

gekennzeichnet durch folgende Merkmale:

Die Sourcezone (3) ist in der zweiten Zone (4) angeordnet;

der Kanal (8) wird in einem an die erste Oberfläche tretenden Teil der zweiten Zone (4), der die Gatezone (6) bildet, erzeugt;

die dritte Zone (1) ist im Vergleich zu den anderen Zonen schwach dotiert und ihr an die erste Oberfläche angrenzender Teil bildet die Drainzone des FET.

2. Thyristor nach Anspruch 1, dadurch gekennzeichnet, dass die Sourcezone des FET vom Nebenschluss (10) entfernt angeordnet ist.

3. Thyristor nach Anspruch 1 oder 2, dadurch gekennzeichnet, dass der die Gatezone (6) des FET bildende Teil der zweiten Zone wenigstens in dem an die erste Oberfläche des Halbleiterkörpers tretenden Bereich dünner als der unterhalb der ersten Zone (2) liegende Teil der zweiten Zone (4) des Thyristors ist.

4. Thyristor nach Anspruch 3, dadurch gekennzeichnet, dass wenigstens ein Teil (7) der Gatezone (6) zur Oberfläche hin schräg ansteigend angeordnet ist.

5. Thyristor nach Anspruch 4, dadurch gekennzeichnet, dass die Gateelektrode (17) aus hochdotiertem polykristallinem Silicium besteht, dass sie wenigstens eine zu einem ihrer Ränder hin abgeschrägte Flanke (18) hat, und dass der schräg ansteigende Teil (7) der Gatezone (6) unter der abgeschrägten Flanke (18) parallel zu dieser verlaufend angeordnet ist.

6. Thyristor nach einem der Ansprüche 1 bis 5, dadurch gekennzeichnet, dass mindestens die erste Zone (2) des Thyristors, die Sourcezone (3) sowie die Gatezone (6) des FET durch Ionenimplantation hergestellt sind.

7. Thyristor nach einem der Ansprüche 1 bis 6, dadurch gekennzeichnet, dass die Sourcezone (3) auf ihrer der auf der ersten Zone (2) befindlichen Elektrode (9) zugewandten Seite über einen Nebenschluss (19) mit der zweiten Zone (4) verbunden ist.

## Claims

1. A thyristor having a semiconductor body with the features:

the semiconductor body has four zones (2, 4, 1, 5) of alternating conductivity type;

respective pn-junctions (13, 14, 16) are arranged between the zones;

the first zone (2) is arranged on the first surface of the semiconductor body;

the second zone (4) borders on the first zone (2) and appears at the first surface;

the third zone (1) borders on the second and fourth zones and appears on the first surface;

the first zone (2) is contacted with an electrode (9) and is connected to the second zone (4) by means of a shunt (10);

an FET is integrated into the same semiconductor body, which FET is intended to bridge the pn-junction lying between the second and third zones;

the source and drain zones (3, 1) of the FET are arranged on the first surface;

characterised by the following features;

the source zone (3) is arranged in the second zone (4);

the channel (8) is produced in a section of the second zone (4) which appears at the surface and forms the gate zone (6);

compared with the other zones, the third zone (1) is weakly doped and the part of it which adjoins the first surface forms the drain zone of the FET.

2. A thyristor as claimed in Claim 1, characterised in that the source zone of the FET is arranged so as to be spaced from the shunt (10).

3. A thyristor as claimed in Claim 1 or Claim 2, characterised in that, at least in the region which appears at the first surface of the semiconductor body, the part of the second zone which forms the gate zone (6) of the FET is thinner than the part of the second zone (4) of the thyristor which lies beneath the first zone (2).

4. A thyristor as claimed in Claim 3, characterised in that at least a part (7) of the gate zone (6) is arranged so as to rise obliquely towards the surface.

5. A thyristor as claimed in Claim 4, characterised in that the gate electrode (17) consists of highly doped polycrystalline silicon, that it has at least one flank (18) which slopes towards one of its edges, and that the obliquely rising part (7) of the gate zone (6) is arranged beneath the sloping flank (18) so as to run parallel thereto.

6. A thyristor as claimed in one of Claims 1 to 5, characterised in that at least the first zone (2) of the thyristor, the source zone (3), and the gate zone (6) of the FET, are produced by ion implantation.

7. A thyristor as claimed in one of Claims 1 to 6, characterised in that the source zone (3) is connected by way of a shunt (19) to the second zone (4) at its side facing the electrode (9) which is arranged on the first zone (2).

## Revendications

1. Thyristor avec un corps semiconducteur ayant les caractéristiques suivantes:

le corps semiconducteur possède quatre zones (2, 4, 1, 5) de type de conductibilité alternée;

entre les zones se situe respectivement une jonction pn (13, 14, 16);

la première zone se situe au niveau de la première surface du corps semiconducteur; la seconde zone (4) est contiguë à la première zone (2) et apparaît à la première surface;

la troisième zone (1) est contiguë à la seconde et à la quatrième zone et apparaît à la première surface;

la première zone (2) est contactée avec une électrode (9) et est reliée à la seconde zone (4) par l'intermédiaire d'une dérivation (10);

dans le même corps semiconducteur est intégré un transistor à effet de champ qui est destiné à ponter la jonction pn (14) qui est située entre la seconde et la quatrième zone;

les zones de source et de drain (3, 1) du transistor à effet de champ se situent au niveau de la première surface,

caractérisé par les moyens suivants:

la zone de source (3) est disposée dans la seconde zone (4);

le canal est produit dans une partie de la seconde zone (4) qui apparaît au niveau de la première surface, et qui forme la zone de grille (6);

la troisième zone (1) est, comparativement aux autres zones, faiblement dopée, et sa partie qui est contiguë à la première surface forme la zone de drain du transistor à effet de champ.

2. Thyristor selon la revendication 1, caractérisé par le fait que la zone de source du transistor à effet de champ est disposée en position éloignée de la dérivation (10).

3. Thyristor selon la revendication 1 ou 2, caractérisé par le fait que la partie de la seconde zone, qui forme la zone de grille (6) du transistor à effet de champ est, au moins dans la plage qui apparaît au niveau de la première surface du semiconducteur, plus mince que la partie de la seconde zone (4) du thyristor, qui se situe en-dessous de la première zone (2).

4. Thyristor selon la revendication 3, caractérisé par le fait qu'au moins une partie (7) de la zone de grille (6) est disposée de manière à être inclinée vers le haut en direction de la surface.

5. Thyristor selon la revendication 4, caractérisé par le fait que l'électrode de grille (17) est constituée par du silicium polycristallin fortement dopé, qu'elle possède au moins un flanc (18) oblique en direction de ses bords, et que la partie oblique (7) de la zone de grille (6) qui s'étend obliquement vers le haut, est disposée sous le flanc incliné (18) en s'étendant parallèlement à celui-ci.

6. Thyristor selon l'une des revendications 1 à 5, caractérisé par le fait qu'au moins la première zone (2) du thyristor, la zone de source (3) de même que la zone de grille (6) du transistor à effet de champ sont réalisées par implantation d'ions.

7. Thyristor selon l'une des revendications 1 à 6, caractérisé par le fait que la zone de source (3) est reliée du côté qui est voisin de l'électrode (9) qui se situe sur la première zone (2), à la seconde zone (4), par l'intermédiaire d'une dérivation (19).

FIG 1

A

p+    5

16    Thyr.

R2

D    FET

n⁻    14    1    G

S

R1    p+    13

14    4

n+    2

K

FIG 2

10    9    2    11    19    3    8    18    17

n+

13    n+    n+    p+    7    1

R1    6

p+    14    4    16    n⁻

p+    p+    5

Thyr. ← + → FET

FIG 3

R2

5

$p^+$

10

9

R1

11

$n^+$

2

4

19

$n^+$

$p^+$

8 3

17

7

6

$n^+$

$n^-$

1

FET ← → Thyr.